Europäisches Patentamt

European Patent Office

Office européen des brevets

(11) Veröffentlichungsnummer: **0 030 592**
**B1**

(12) **EUROPÄISCHE PATENTSCHRIFT**

(45) Veröffentlichungstag der Patentschrift: **18.01.84**

(21) Anmeldenummer: **80105964.3**

(22) Anmeldetag: **02.10.80**

(51) Int. Cl.³: **G 01 R 31/08,**
**G 01 R 17/16, G 01 R 27/26**

(54) Verfahren zum Orten von Erdfehlern in Leitungen.

(30) Priorität: **08.12.79 DE 2949467**

(43) Veröffentlichungstag der Anmeldung:
**24.06.81 Patentblatt 81/25**

(45) Bekanntmachung des Hinweises auf die Patenterteilung:
**18.01.84 Patentblatt 84/3**

(84) Benannte Vertragsstaaten:
**AT CH FR GB IT LI NL SE**

(56) Entgegenhaltungen:
**DE - A - 2 833 141**
**DE - B - 1 801 158**

**JOURNAL OF PHYSICS E., Band 6, Nr. 7, 1973**
**D.K. STANKOVIC "Simple Thermistor**
**Temperature-To-Frequency Converter Based on**
**an Astable Multivibrator" Seiten 601 bis 602**
**RADIO & ELECTRONICS CONSTRUCTOR, Band**
**27, Nr. 12, July 1974 G.A. FRENCH**
**"Multivibrator Capacitance Bridge" Seiten 730**
**bis 732**

(73) Patentinhaber: **Philips Kommunikations Industrie**
**AG**
**Thurn-und-Taxis-Strasse 10**
**D-8500 Nürnberg 10 (DE)**

(72) Erfinder: **Biedermann, Udo**
**Bergengruenstrasse 34**
**D-5000 Köln 91 (DE)**
Erfinder: **Volkmann, Klaus, Dipl.-Ing.**
**Feldstrasse 121/A**
**D-5060 Berg.Gladbach 2 (DE)**

Verfahren zum Orten von Erdfehlern in Leitungen

Die vorliegende Erfindung betrefft ein Verfahren zum Orten von Erdfehlern in Leitungen, bei dem die zu untersuchende Leitung in einem ersten Arm einer Meßbrücke angeordnet wird, welche einen mit dem ersten Arm verbunden zweiten Arm in Form einer fehlerfreien Leitung aufweist, die Meßbrücke aus einer geerdeten Meßspannungsquelle mit Strom versorgt wird und die Meßbrücke durch Einstellung von Brückenparametern abgeglichen wird.

Allgemein bekannt für die Ortung von Erdfehlern an Kabeln und Leitungen ist die Meßbrückenschaltung nach Murray ("Fehlerortungen" von Dr.-Ing. E. Widl, Dr. Alfred Hüthig-Verlag GmbH, Heidelberg, 1962, Seiten 22—24). Hierbei bildet eine fehlerfreie Leitungsader und das mit ihr verbundene, hinter dem Erdfehler liegende Ende der gestörten Leitungsader einen Brückenzweig, während das vor dem Erdfehler liegende Teilstück der fehlerbehafteten Ader den zweiten Brückenzweig bildet. Die beiden anderen Brückenzweige werden durch ein Potentiometer oder eine Widerstands-Potentiometeranordnung dargestellt. Zwischen dem Abgriff des Potentiometers und einem Erdanschluß wird die Meßspannungsquelle geschaltet. Ein Nullinstrument, das zwischen den beiden zugänglichen Enden der genannten Leitungsardern liegt, dient zum Abgleich der Brücke durch Einstellung des Potentiometers.

Diese bekannte Brückenschaltung hat eine Reihe von Nachteilen, die die Messung erschweren und eine genaue Fehlerorts-Bestimmung aufwendig machen. Die Brückenschaltung muß manuell abgeglichen werden, die Fehlerortsentfernung muß nach der Potentiometereinstellung errechnet werden. Die Fehlergrenze der Anordnung wird direkt durch die Qualität des verwendeten Potentiometers bestimmt. Die Kosten für ein genügend genaues Potentiometer sind sehr hoch, die Genauigkeit vermindert sich im Laufe der Lebensdauer. Ferner muß die defekte Ader und die gesunde Ader an den ihnen zugeordneten Klemmen der Meßanordnung angeschlossen werden. Hinzu kommt, daß beim Auftreten von Störspannungen die Messung gestört oder ganz unmöglich gemacht wird.

Der Erfindung liegt die Aufgabe zugrunde, die Genauigkeit des Meßverfahrens wesentlich zu vergrößern, die Bedienung zu vereinfachen und die Voraussetzung für eine direkte Anzeige der Meßwerte zu schaffen.

Diese Aufgabe wird erfindungsgemäß dadurch gelöst, daß die nicht miteinander verbundenen Enden des ersten und zweiten Arms der Meßbrücke mittels eines Umschalters periodisch wechselweise an die Spannungsquelle angeschlossen werden und der Abgleich der Meßbrücke durch Einstellung des Verhältnisses der · Anschlußzeiten der beiden Arme an die Meßspannungsquelle vorgenommen wird, und daß das im abgeglichenen Zustand der Meßbrücke vorliegende Verhältnis der Anschlußzeiten gemessen und angezeigt wird.

Weitere Ausgestaltungen der Erfindung sind in den Unteransprüchen 2 bis 10 enthalten.

Ausführungsbeispiele der Erfindung sind in der Zeichnung dargestellt und werden im folgenden näher beschrieben. Es zeigen:

Fig. 1 eine prinzipielle Darstellung einer Schaltungsanordnung zur Veranschaulichung des Verfahrens nach der Erfindung,

Fig. 2 ein Blockschaltbild einer Schaltungsanordnung zur Durchführung des erfindungsgemäßen Verfahrens,

Fig. 3 eine Darstellung der zeitlichen Spannungsverläufe an den wichtigsten Punkten der Schaltung,

Fig. 4 ein Blockschaltbild einer Schaltungsanordnung mit weiteren Ausgesteltungen,

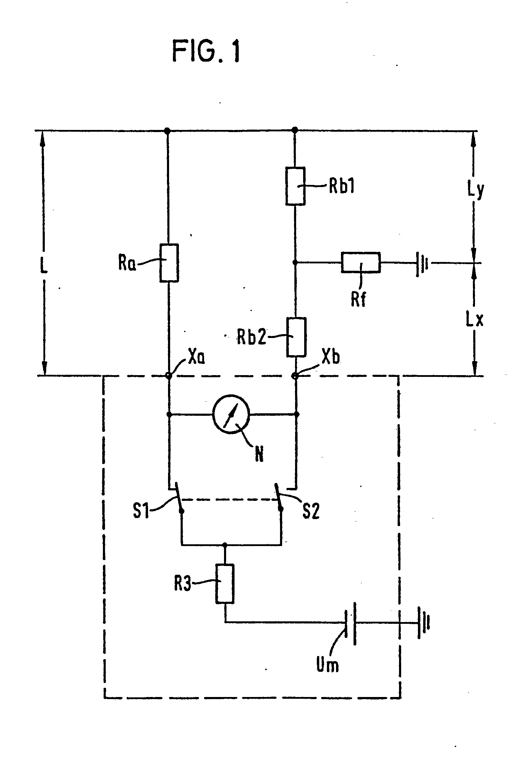

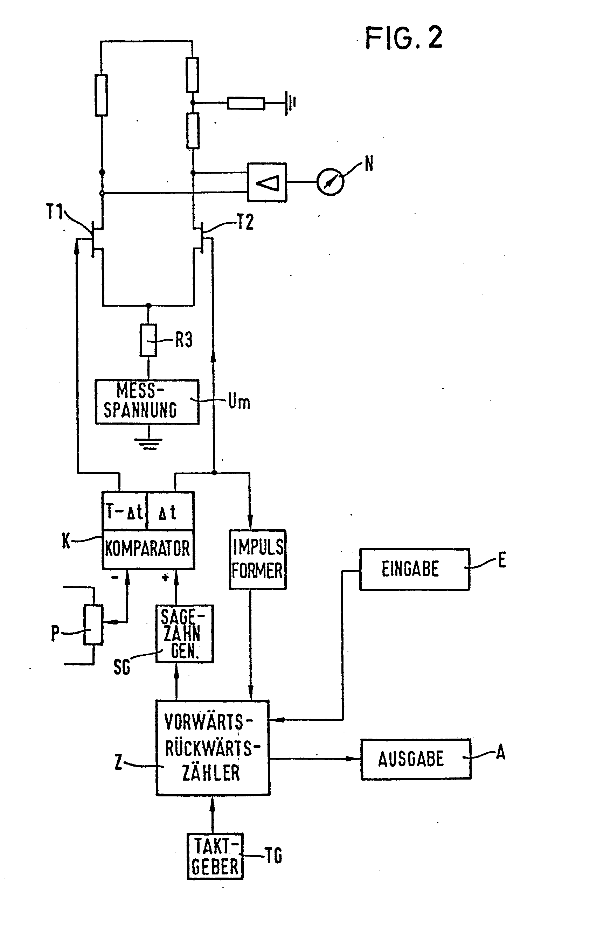

Fig. 1 zeigt das Prinzipschaltbild einer Meßanordnung mit den für die Erläuterung des Verfahrens wichtigen Einzelheiten. Die fehlerbehaftete Leitung habe die Länge 1. Die fehlerfreie Ader a wird durch ihren Aderwiderstand Ra dargestellt. Diese Ader a ist am fernen Ende der Leitung mit der fehlerhaften Ader b verbunden, die fehlerhafte Ader b wird durch ihre Aderwiderstände Rb1 hinter dem Erdfehler und Rb2 vor dem Erdfehler dargestellt. Der Erdfehler ist durch seinen Fehlerwiderstand Rf angedeutet. Die Entfernung vom Meßpunkt bis zum Erdfehler betrage 1x. Die Entfernung vom Fehler bis zum fernen Leitungsende ist mit 1y bezeichnet. Der Abgleich der Brückenschaltung erfolgt mit Hilfe des Nullinstruments N. Ein die Leitungsadern verbindendes und zwei weitere Brückenzweige bildendes Potentiometer aus bekannten Meßbrücken ist durch den Umschalter S1 und S2 mit veränderbarem Schaltzeit-Verhältnis ersetzt. Die Verbindung der beiden Schalterkontakte S1 und S2 ist über den Strombegrenzungswiderstand R3 mit der Meßspannungsquelle Um verbunden, deren zweiter Pol an Erde liegt. Es ist ohne nähere Erläuterung erkennbar, daß unter bestimmten Voraussetzungen, beispielsweise genügend hoher Schaltfrequenz fm oder entsprechend hoher Trägheit des Nullinstruments N ein Nullabgleich der Brückenschaltung durch Verändern des Schaltzeit-Verhältnisses des Umschalters S1 und S2 möglich ist. In der Praxis wird man die in Fig. 1 angedeuteten mechanischen Umschalter S1 und S2 durch steuerbare Halbleiter-Bauelemente ersetzen, wie dies in Fig. 2 gezeigt und später erläutert wird. Damit sind ohne weiteres genügend hohe Schaltfrequenzen fm oder kleine Schaltzeiten T=1:fm zu erreichen, so daß an die Trägheit des Nullinstruments N keine besonderen Anforderungen gestellt werden brauchen. Es ist ferner erkennbar, daß der Einfluß eventueller Unterschiede der Durchlaßwiderstände der als Umschalter S1 und S2 verwendeten Halbleiter-Bauelemente auf die Meßgenauigkeit durch das Einfügen eines genügend großen Strombegrenzungsgliedes, hier durch einen Widerstand R3 dargestellt, in die Verbindungsleitung zwischen dem Umschalter S1 und S2 und der Meßspannungsquelle in jedem gewünschten maß vermindert werden kann.

Fig. 2 zeigt die erweiterte Darstellung einer Schaltungsanordnung zur Durchführung des Verfahrens als Blockschaltbild. Das in Fig. 1 bereits ausführlich beschriebene Meßobjekt ist im oberen Teil der Darstellung vereinfacht und ohne Bezugszeichen wiedergegeben. Das Nullinstrument N ist mit einem Verstärker versehen, um seine Empfindlichkeit beliebig zu erhöhen und damit die Meßenauigkeit verbessern zu können. Die Umschalter S1 und S2 wurden durch steuerbare Halbleiter-Bauteile T1 und T2 ersetzt. In der Fig. 2 sind sie als Feldeffekt-Transistoren angedeutet. Es können aber auch andere geeignete Transistortypen oder moderne digitale Halbleiter-Bauelemente verwendet werden. Die Meßspannungsquelle Um ist wider über einen Strombegrenzungs-Widerstand R3 mit dem Umschalter verbunden, an seine Stelle kann aber auch eine Konstanstrom-Quelle treten. Der Ausgang eines Komparators K liefert durch seine Eingangsbedingungen veränderbare Impulse, die nach entsprechender Aufbereitung als Steuerspannungen den Halbleiter-Bauelementen T1 und T2 zugeführt werden. Der Minuseingang des Komparators K liegt an einer durch das Potentiometer P einstellbaren Gleichspannung, die mit einer aus dem Sägezahngenerator SG kommenden Sägezahnspannung verglichen wird. Es ist erkennbar, daß durch Veränderung der Gleichspannung das Anschlußzeit-Verhältnis $\Delta t/(t-\Delta t)$ in weiten Grenzen verändert werden kann und dadurch ein Nullabgleich der Brück durchgeführt werden kann. Das Startsignal für jeden Sägezahn aus dem Sägezahngenerator SG kommt von einem Ausgang eines Vorwärts-Rückwärts-Zählers Z. Dieser wird wiederum gesteuert von einem Taktgeber TG, dessen Clock-Frequenz ein Vielfaches, beispielsweise das 20000-fache der gewünschten Meßfrequenz fm ist. Aus der Steuerspannung für das Halbleiter-Bauelement T2 wird durch einen Impulsformer ein Anzeigebefehl an den Vorwärts-Rückwärts-Zähler Z gebildet, so daß dessen Ausgabe A die Zahl der vom Taktgeber TG gelieferten Impulse während der Schließzeit $\Delta t$ des Bauelements T2 anzeigt. Es läßt sich zeigen, daß diese Anzeige direkt proportional der Entfernung des Erdfehlers vom Kabelanfang ist. Der maximale Zählerstand des Vorwärts-Rückwärts-Zählers Z läßt sich mit einem Kodierschalter, der Eingabe E, auf beliebige Werte einstellen. Wird an der Eingabe E die bekannte Gesamtlänge 1 der zu messenden Leitung in beliebigen Einheiten eingegeben, so läßt sich zeigen, daß im abgeglichenen Zustand der Brücke an der Ausgabe A die Länge 1x der Leitung bis zum Fehlerort erscheint.

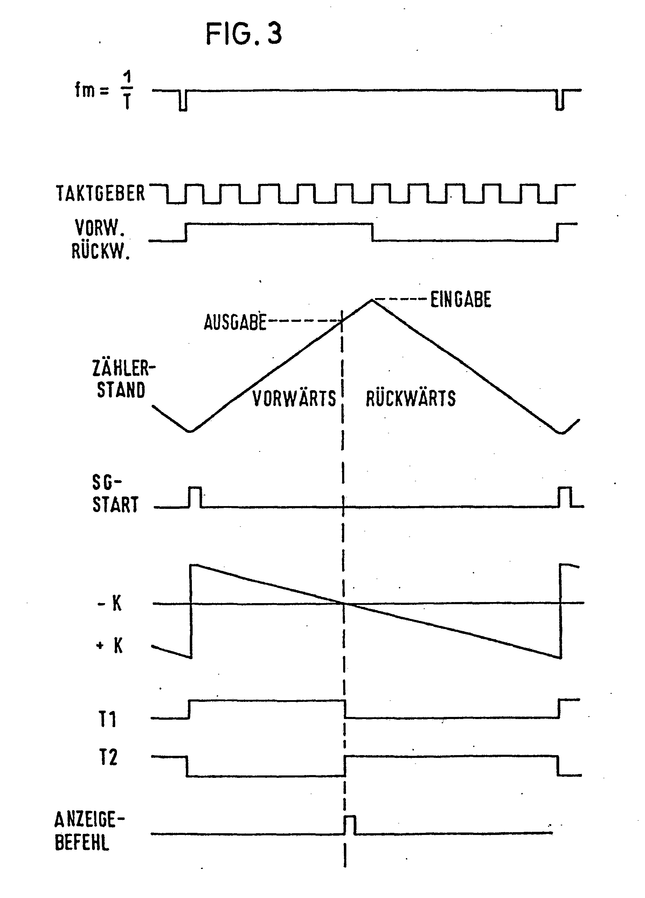

In Fig. 3 ist eine Reihe von zeitlichen Spannungsverläufen schematisch dargestellt, wie sie sich an einigen Punkten der Schaltungsanordnung gemäß Fig. 2 im abgeglichenen Zustand der Brücke ergeben. Im oberen Teil der Darstellung ist ein Impuls dargestellt, der die Zeitdauer T, die Dauer des Meßzyklus hat. Seine Impulsfrequenz fm ist also 1:T. Seine Zeitdauer ergibt sich nach Fig. 3 aus der Zahl der darunter dargestellten Taktgeberimpulse, die mit der Eingabe E vorgewählt wurde. Aus diesen beiden dargestellten Impulsreihen wird die dritte dargestelle Impulsreihen abgeleitet, bei der die Zeitdauer der Einzelimpulse T:2 beträgt. Diese Impulsreihe wird benutzt, um den Zähler Z von Vorwärts- auf Rückwärtszählen umzuschalten. Der sich so ergebende jeweilige Zählerstand ist darunter dargestellt. Aus der ersten Impulsreihe werden die Startimpulse für den Sägezahngenerator SG abgeleitet. Der Sägezahngenerator SG liefert den darunter dargestellten Sägezahn, der am Pluseingang des Komparators K anliegt. Am Minuseingang des Komparators K liegt die ebenfalls dargestellte Gleichspannung, die dem Potentiometer P entnommen wird. Die am ausgang des Komparators K bei Gleichheit der beiden verglichenen Spannung auftretenden Impulse werden umgeformt, aufbereitet und dienen als Steuerspannung für die Halbleiter-Schaltglieder T1 und T2. Die zeitlichen Verläufe der beiden Steuerspannungen sind unter dem Sägezahn dargestellt. Aus der Steuerspannung für das Schaltglied T2 wird wiederum der Anzeigebefehl abgeleitet, der die Ausgabe A veranlaßt, den zu diesem Zeitpunkt erreichten Zählerstand anzuzeigen.

Es läßt sich erkennen, daß eine Schaltungsanordnung gemäß Fig. 2 noch einige Nachteile der bekannten Brückenschaltungen aufweist. Bei dieser Anordnung muß der Nullabgleich noch manuell erfolgen, die Anzeige der Ausgabe A ist nur dann eindeutig, wenn die fehlerhafte Ader an den ihr zugeordneten Anschluß der Meßanordnung angelegt ist. Weiterhin ergibt sich, daß die Meßfrequenz fm abhängig ist von dem an der Eingabe E eingestellten Wert.

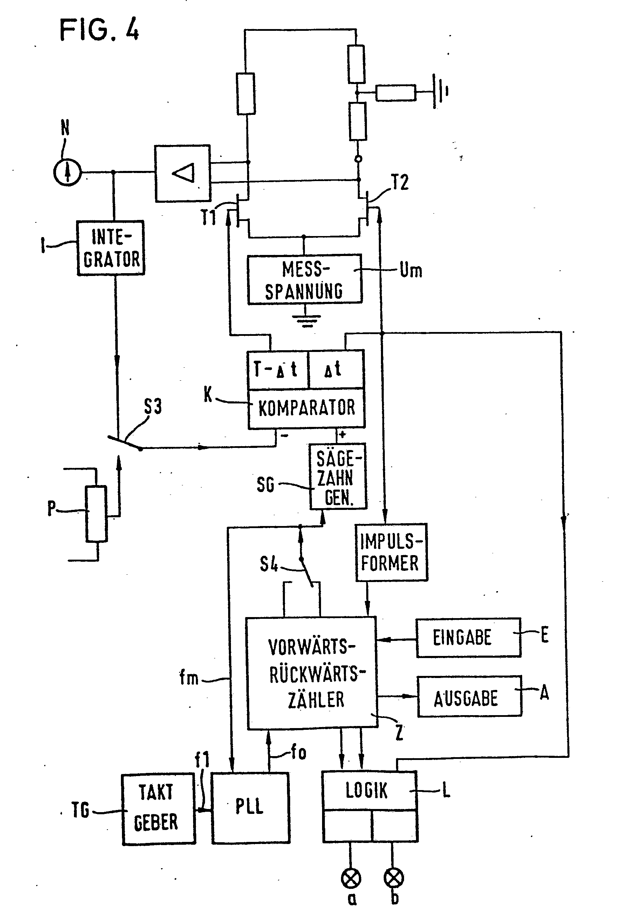

In Fig. 4 ist eine gegenüber der Schaltungsanordnung nach Fig. 2 erweiterte Anordnung als Blockschaltbild schematisch dargestellt. Gleiche Teile tragen die gleichen Bezugszeichen wie in Fig. 2. Der Minuseingang des Komparators K kann hier über einen Schalter S3 an das bereits beschriebenen Potentiometer P gelegt werden. In der gezeichneten Stellung des Schalters S3 liegt der Minuseingang jedoch am Ausgang eines Integrators I, an dessen Eingang die am Nullinstrument N anstehende Spannung liegt. Es ist erkennbar, daß die Ausgangsspannung des Integrators erst dann einen konstanten Wert annimmt, wenn die Nullspannung gleich Null ist, daß heißt, daß die Brückenschaltung abgeglichen ist. Dieser Abgleich erfolgt also selbständig. Das bedeutet eine wesentliche Vereinfachung des Meßvorganges. Weiterhin ist eine Logikshaltung L dargestellt, die die Steuerspannung für das Schaltglied T2 mit Signalen des Zählers Z vergleicht, die die Zählart des Zählers Z "Vorwärts" oder "Rückwärts" signalisieren. Auf diese Weise wird angezeigt, in welcher der angeschlossenen Leitungsadern der angezeigt Fehlerort aufgetreten ist. Diese Möglichkeit hat den Vorteil, daß bei Anschluß der Leitungsadern die Bezeichnung der Anschlüsse nicht mehr beachtet werden braucht und dennoch ein eindeutiges Meßergebnis vorliegt. Eine weitere Ausgestaltung besteht darin, daß die den Zähler Z steuernde Taktfrequenz fo in einer Phase-Locked-Loop-Schaltung PLL erzeugt und so eingestellt wird, daß die den Sägezahngenerator SG startende Meßfrequenz fm gleich der festen Frequenz f1 des Taktgebers TG wird. Diese Anordnung hat den Vorteil, daß die Schaltperiode T des Umschalters T1, T2 unabhängig von der Eingabe E konstant gehalten werden kann.

Das beschriebene Verfahren und die dargestellte Schaltungsanordnung gemäß Fig. 4 zur Durchführung des Verfahrens bietet nun folgende Möglichkeit:

1. Messung der Fehlerortsentfernung in Prozent oder Promille der Leitungslänge oder des Aderwiderstandes, wenn als Eingabe E volle Dekaden wie 100, 1000 eingestellt werden.
2. Messung der Fehlerortsentfernung in Längeneinheiten, wenn in der Eingabe E die Länge der Leitung in Metern, Kilometern oder in irgend einer anderen Einheit eingegeben wird.
3. Freier Anschluß von defekter und gesunder Ader, da angezeigt wird, welche der Adern den Defekt aufweist.
4. Manueller Nullabgleich der Brückenanordnung, wenn dieses gewünscht wird.
5. Selbsttätiger Nullabgleich der Anordnung, wenn sich der Schalter S3 in der gezeichneten Stellung befindet.

Beim bisher beschriebenen Meßverfahren wird der Startimpuls für den Sägezahngenerator SG vom Zähler Z gegeben, sobald sich dieser in Nullstellung befindet. Durch Umlegen des Schalters S4 kann der Startimpuls aber auch ausgelöst werden, wenn der interne Zählerstand des Vorwärts-Rückwärts-Zählers Z dem vorgegebenen Wert der Eingabe E entspricht. Dadurch wird aus der Fehlerortmeßschaltung eine Widerstandsdifferenzmeßschaltung, die zusätzlich folgende Messungen ermöglicht:

6. Relative Widerstandsdifferenz der beiden Adern in Prozent, Promille oder anderen Bruchteilen vom Schleifenwiderstand, wenn in der Eingabe E die entsprechenden dekadischen Werte eingestellt werden.
7. Absolute Widerstandsdifferenz der beiden Adern, wenn in der Eingabe E der Schleifenwiderstand eingestellt wird.

8. Fehlerortsmessung wie unter 1 und 2 aufgeführt, vom Leitungsanfang her gemessen, aber vom Kabelende her angezeigt.

Auch diese Meßmöglichkeiten können sowohl mit manuellem als auch selbsttätigem Nullabgleich der Brückenanordnung erfolgen. Es ist ersichtlich, daß Verfahren und Schaltungsanordnung auch zum Vergleich eines unbekannten Widerstandes mit einem Normalwiderstand benutzt werden kann. Es ist also auch die Bestimmung von Absolutwerten unbekannter Widerstände möglich. Eine direkte Anzeige von absoluten Widerstandswerten kann bei Benutzung des selbsttätigen Abgleichs dadurch erreicht werden, daß man die den Zähler Z steuernde Taktfreuenz fO auf bestimmte vorgewählte Werte einstellt. Wird hierbei der Zählerüberlauf überwacht und daraus eine Umschaltung der entsprechenden Normalwiderstände oder der Clockfrequenz abgeleitet, ergibt sich daraus eine automatische Bereichswahl für die Widerstandsmessung.

**Patentansprüche**

1. Verfahren zum Orten von Erdfehlern in Leitungen, bei dem die zu untersuchende Leitung (RB1, RB2) in einem ersten Arm einer Meßbrücke angeordnet wird, welche einen mit dem ersten Arm verbundenen zweiten Arm in Form einer fehlerfreien Leitung aufweist, die Meßbrücke aus einer geerdeten Meßspannungsquelle (Um) mit Strom versorgt wird, die Meßbrücke durch Einstellung von Brückenparametern abgeglichen wird, dadurch gekennzeichnet, daß die nicht miteinander verbundenen Enden des ersten und zweiten Arms der Meßbrücke mittels eines Umschalters (S1, S2) periodisch wechselweise an die Spannungsquelle (Um) angeschlossen werden, der Abgleich der Meßbrücke durch Einstellung des Verhältnisses der Anschlußzeiten der beiden Arme an die Meßspannungsquelle vorgenommen wird, und daß das im abgeglichenen Zustand der Meßbrücke vorliegende Verhältnis der Anschlußzeiten gemessen und angezeigt wird.

2. Verfahren nach Anspruch 1, dadurch gekennzeichnet, daß als Umschalter (S1, S2) steuerbare Halbleiter-Bauelemente (T1, T2) verwendet werden.

3. Verfahren nach Anspruch 1 oder 2, dadurch gekennzeichnet, daß der Einfluß eventueller Unterschiede der Durchlaß-Widerstände der Umschalter-Bauelemente (T1, T2) auf die Meßgenauigkeit durch Einfügen eines Strombegrenzungsgliedes (R3) in die Verbindungsleitung zwischen dem Umschalter (S1, S2) und der Meßspannungsquelle (Um) vermindert wird.

4. Verfahren nach einem der Ansprüche 1 bis 3, dadurch gekennzeichnet, daß das Anschlußzeit-Verhältnis des Umschalters (S1, S2) durch einen von einem Taktgeber (TG) gesteuerten digitalen Vorwärts-Rückwärts-Zähler (Z) gemessen und angezeigt wird.

5. Verfahren nach Anspruch 4, dadurch gekennzeichnet, daß der Vorwärts-Rückwärts-Zähler (Z) durch Eingabe (E) eines der Leitungslänge (1) entsprechenden maximalen Zählwerts für die Absolut-Ausgabe (A) des Meßwertes programmiert wird.

6. Verfahren nach einem der Ansprüche 1 bis 5, dadurch gekennzeichnet, daß das Anschlußzeit-Verhälnis des Umschalters (S1, S2) für den Brückenabgleich über einen Komparator (K) durch Vergleich einer Sägezahnspannung mit einer einstellbaren Bezugsspannung eingestellt wird.

7. Verfahren nach einem der Ansprüche 1 bis 5, dadurch gekennzeichnet, daß das Anschlußzeit-Verhältnis des Umschalters (S1, S2) für einen selbsttätigen Brückenabgleich über einen Komparator (K) durch Vergleich einer Sägezahnspannung mit der integrierten Spannung des Brücken-Nullzweiges geregelt wird.

8. Verfahren nach Anspruch 5, dadurch gekennzeichnet, daß die Schaltperiode (T) des Umschalters (S1, S2) konstant gehalten wird, un daß die den Vorwärts-Rückwärts-Zähler (Z) steuernde Taktfrequenz (FO) entsprechend der Eingabe (E) des maximalen Zählwerts geändert wird.

9. Verfahren nach Anspruch 8, dadurch gekennzeichnet, daß die Taktfrequenz (f0) in einer Phase-Locked-Loop-Schaltung (PLL) erzeugt wird, deren erstem Eingang eine konstante Taktgeber-Frequenz (f1) und deren zweitem Eingang die Meßfrequenz (fm=1:t) zugeführt wird.

10. Verfahren nach einem der Ansprüche 6 bis 9, dadurch gekennzeichnet, daß eine Logikschaltung (L) zwischen einen Ausgang des Komparators (K) und die Zählrichtung anzeigende Hilfsanschlüsse des Zählers (Z) geschaltet wird, deren Ausgänge die fehlerhafte Ader anzeigen.

**Revendications**

1. Procédé pour localiser sur des lignes conductrices des défauts d'isolement par rapport à la terre, dans lequel la ligne à contröler (RB1, RB2) est disposée dans un premier bras d'un pont de mesure, qui présente un second bras constitué par une ligne sans défaut, connecté avec le premier bras, le pont de measure est alimenté en courant à partir d'une source de tension de mesure (Um) mise à la terre, le pont de mesure est équilibré par réglage de paramètres de pont, caractérisé en ce que les extrémités non connectées ensemble du premier et du second bras du pont de mesure sont raccordées périodiquement alternativement au moyen d'un commutateur (S1, S2) à la source de tension (Um), l'équilibrage du pont de mesure étant assuré par réglage du rapport des temps de connexion des deux bras à la source de tension de mesure, et en ce que le rapport des temps de connexion présent à l'état équilibré du pont est mesuré et affiché.

2. Procédé selon la revendication 1, caractérisé en ce que l'on utilise comme commutateur (S1, S2) des composants semi-conducteur commandés (T1, T2).

3. Procédé selon une des revendications 1 ou 2, caractérisé en ce que l'influence de différences éventuelles des résistances de passage des composants (T1, T2) de commutateur sur la précision de mesure est réduite par insertion d'une élément limiteur de courant (R3) dans le conducteur de liaison entre le commutateur (S1, S2) et la source de tension de mesure (Um).

4. Procédé selon une des revendications 1 à 3, caractérisé en ce que le rapport des temps de connexion du commutateur (S1, S2) est mesuré et indiqué par un compteur digital avant-arrière (Z) commandé par un générateur d'impulsion (TG).

5. Procédé selon la revendication 4, caractérisé en ce que le compteur avant-arrière (Z) est programmé par une entrée (E) d'une valeur de compteur maximale correspondant à la longueur du conducteur (1), pour la sortie absolue (A) de la valeur de la mesure.

6. Procédé selon une des revendications 1 à 5, caractérisé en ce que le rapport des temps de connexion du commutateur (S1, S2) pour l'équilibrage du pont est réglé par un comparateur (K) par comparaison d'une tension en dents de scie avec une tension de référence réglable.

7. Procédé selon une des revendications 1 à 5, caractérisé en ce que le rapport des temps de connexion du commutateur (S1, S2) pour un équilibrage automatique du pont est réglé par un comparateur (K), par comparaison d'une tension en dents de scie avec la tension intégrée de la branche nulle du pont.

8. Procédé selon la revendication 5, caractérisé en ce que la période de commutation (T) du commutateur (S1, S2) est maintenue constante et que la fréquence d'impulsion (f0) commandant le compteur avant-arrière (Z) est modifiée en fonction de l'entrée (E) de la valeur de compteur maximale.

9. Procédé selon la revendication 8, caractérisé en ce que la fréquence d'impulsion (f0) est produite dans un montage en boucle d'accrochage de phase (PLL), dont la première entrée reçoit une fréquence d'impulsions constante (f1) et la seconde entrée la fréquence de mesure (fm=1:T).

10. Procédé selon une des revendications 6 à 9, caractérisé en ce qu'un montage logique (L) est connecté entre une sortie du comparateur (K) et les connexions auxiliaires indiquant le sens de comptage du compteur (Z), dont les sorties indiquent le conducteur en défaut.

**Claims**

1. Method for the location of earth faults in lines, in which the line (RB1, RB2) to be examined is arranged in a first arm of a measuring bridge which displays a second arm in the form of a faultless line connected with the first arm, the measuring bridge is supplied with current from an earthed measuring voltage source (Um) and the measuring bridge is balanced by the setting of bridge parameters, characterised thereby, that those ends of the first and second arms of the measuring bridge, which are not connected each with the other, are periodically connected alternately to the voltage source (Um) by means of a change-over switch (S1, S2), the balancing of the measuring bridge is undertaken through setting of the ratio of the connection times of both the arms to the measuring voltage source and that the ratio of the connection times, which is present in the balanced state of the measuring bridge, is measured and indicated.

2. Method according to claim 1, characterised thereby, that controllable semiconductor constructional elements (T1, T2) are used as change-over switch (S1, S2).

3. Method according to claim 1 or 2, characterised thereby, that the influence of possible differences in the forward resistances of the change-over switch constructional elements (T1, T2) on the measurement accuracy is reduced through the insertion of a current-limiting member (R3) into the connecting line between the change-over switch (S1, S2) and the measuring voltage source (Um).

4. Method according to one of the claims 1 to 3, characterised thereby, that the ratio of the connection times of the change-over switch (S1, S2) is measured and indicated by a reversible digital counter (Z) controlled by a pulse generator (TG).

5. Method according to claim 4, characterised thereby, that the reversible counter (Z) is programmed by the input (E) of a maximum count value, which corresponds to the length (l) of the line, for the absolute output (A) of the measurement value.

6. Method according to one of the claims 1 to 5, characterised thereby, that the ratio of the connection times of the change-over switch (S1, S2) for the bridge balance is set through a comparator (K) by comparison of a sawtooth voltage with a settable reference voltage.

7. Method according to one of the claims 1 to 5, characterised thereby, that the ratio of the connection times of the change-over switch (S1, S2) for an automatic bridge balance is regulated through a comparator (K) by comparison of a sawtooth voltage with the integrated voltage of the zero branch of the bridge.

8. Method according to claim 5, characterised thereby, that the switching period (T) of the change-over switch (S1, S2) is kept constant and that the pulse frequency (f0) controlling the reversible counter (Z) is altered according to the input (E) of the maximum count value.

9. Method according to claim 8, characterised thereby, that the pulse frequency (f0) is generated in a phase-locked loop circuit (PLL), to the first input of which is fed a constant pulse transmitter frequency (f1) and to the second input of which is fed the measurement frequency (fm=1:T).

10. Method according to one of the claims 6 to 9, characterised thereby, that a logic circuit (L) is connected between an output of the comparator (K) and auxiliary connections of the counter (Z), which indicate the counting direction, and has outputs indicating the faulty core.

# FIG. 1

FIG. 2

# FIG. 3

$$fm = \frac{1}{T}$$

TAKTGEBER

VORW.
RÜCKW.

EINGABE

AUSGABE

ZÄHLER-
STAND

VORWÄRTS    RÜCKWÄRTS

SG-
START

- K

+ K

T1

T2

ANZEIGE-
BEFEHL

FIG. 4

N

INTE-GRATOR — I

T1

T2

MESS-SPANNUNG — Um

S3

K — KOMPARATOR | T-Δt | Δt

P

SÄGE-ZAHN GEN. — SG

S4

IMPULS-FORMER

VORWÄRTS-RÜCKWÄRTS-ZÄHLER — Z

EINGABE — E

AUSGABE — A

fm

fo

f1

TG — TAKT GEBER

PLL

LOGIK — L

a    b